# EUROPEAN PATENT APPLICATION

(11) **EP 4 080 718 A1**
(43) Date of publication of application: **26.10.2022**
(21) Application number: 21867195.6
(22) Date of filing: 14.09.2021
(51) Int. Cl.: H02J 7/00, G01R 31/392, G01R 31/3842, G01R 31/396, G01R 27/08, G01R 31/64

(54) **PRE-CHARGE RESISTOR ABNORMALITY DETERMINING METHOD AND BATTERY SYSTEM USING SAME**

(30) Priority: 14.09.2020 KR 20200117949
(71) Applicant: LG Energy Solution, Ltd., Seoul 07335 (KR)
(72) Inventor: KO, Juhyeung, Daejeon 34122 (KR)
(74) Representative: Plasseraud IP
(86) International application number: PCT/KR2021/012507
(87) International publication number: WO 2022/055330

(57) **Abstract**

A battery system includes at least one battery pack including: a plurality of battery cells; a plurality of pre-charge resistors connected to one terminal of the at least one battery pack; a plurality of pre-charge switches of which one terminal is connected to the other terminal of a plurality of pre-charge resistors; a plurality of capacitors connected to the other terminal of a plurality of pre-charge switches; and a main control circuit that determines whether a plurality of pre-charge resistors are abnormal according to a result of comparing a sum of a plurality of branch currents calculated by using a pre-stored value of a plurality of resistances of the plurality of pre-charge resistors and the voltage of both terminals of a plurality of pre-charge resistors with a battery current flowing through at least one battery pack, when the first period has elapsed during the performing of the pre-charge operation.

## Description

### BACKGROUND OF THE INVENTION

### (a) Field of the Invention

### [Technical Field]

### CROSS-REFERENCE TO RELATED APPLICATION

This application claims priority to and the benefit of Korean Patent Application No. 10-2020-0117949 filed in the Korean Intellectual Property Office on September 14, 2020, the entire contents of which are incorporated herein by reference.

The present disclosure relates to a method of determining an abnormality of a pre-charge resistor and a battery system using the same.

### [Background Art]

As a pre-charge resistor deteriorates, a resistance value increases. Then, a charging time of a pre-charge capacitor connected to the pre-charge resistor is prolonged, and a transition to a drive mode may be delayed during ignition of a vehicle receiving power from the battery system.

In addition, when the battery system includes a plurality of battery packs coupled in parallel, among high voltage load branches coupled in parallel to the battery system, a high current may flow to branches other than the branch to which the degenerated pre-charge resistor is connected. Then, a protective circuit may be damaged due to heat generated by the high current.

In addition, among the high-load load in which insulation is broken due to the damage of the pre-charge resistor among the high-load loads connected to the battery system may occur. Due to the deterioration of the pre-charge resistor, internal resistance of the load connected to the branch through which a lower current than a prescribed condition flows among the branches to which the high-load load is connected to may be lowered.

### [Summary]

### [Technical Problem]

The present disclosure is to provide a method that may determine whether a pre-charge resistor is abnormal and a battery system using the same.

### [Technical Solution]

A battery system according to one aspect of the invention includes: a plurality of battery packs including a plurality of battery cells, each battery pack including a respective first terminal; a plurality of branches, each branch comprising: a respective pre-charge resistor including a first terminal that is connected to each of the first terminals of the plurality of battery packs and a second terminal; a respective pre-charge switch, including a first terminal that is connected to a corresponding second terminal of the pre-charge resistor and a second terminal; a capacitor including a first terminal that is connected to the second terminal of the pre-charge switch; and a main control circuit configured to determine whether the pre-charge resistors of the plurality of branches are operating abnormally based on a comparison of a sum of a plurality of branch currents with a battery current flowing through at least one battery pack, wherein, for each branch, the branch current is calculated using a pre-stored value of a resistance of the pre-charge resistor of the branch and a voltage across the pre-charge resistor of the branch, and wherein the comparison is upon a first period of a pre-charge operation elapsing.

The main control circuit may be configured to calculate, for each branch, a branch charging slope and determine for a branch of the plurality of branches having a branch charging slope smaller than a predetermined reference slope, the pre-charge resistor of the branch is operating abnormally based on a difference between a capacitor voltage of the capacitor of the branch upon a second period of the pre-charge operation elapsing and the capacitor voltage upon a third period of the pre-charge operation elapsing.

The reference slope may be a branch charging slope of a plurality of pre-charge resistors is in a normal state.

The main control circuit may be configured to measure a branch charging time that a voltage charged to the capacitor of the branch reaches a voltage of at least one of the plurality of battery packs, and determine for a branch of the plurality of branches having a branch charging time that is longer than a predetermined reference time, that the pre-charge resistor of the branch is operating abnormally based on the branch charging time.

The reference time may be a branch charging time of a plurality of pre-charge resistors in a normal state.

The first period may correspond to a time constant defined by resistance values of the pre-charge resistors of the plurality of branches and capacitance values of the capacitors of the plurality of branches, and the second period may correspond to a predetermined integer multiple of the time constant.

A method of determining an abnormality of a pre-charge resistor of a battery system including a plurality of battery packs including a plurality of battery cells, each battery pack including a respective first terminal, the battery system further including a plurality of branches, each branch including a respective pre-charge resistor, a respective pre-charge switch, and a respective capacitor, wherein a first terminal of of the respective pre-charge resistor is connected to each respective first terminal of the plurality of battery packs, wherein a first terminal of the respective pre-charge switch is connected to a second terminal of the respective pre-charge resistor, and a first terminal of the respective capacitor is connected to a second terminal of the respective pre-charge switch, may include: for each branch, calculating a branch current of the branch using a pre-stored resistance value of the respective pre-charge resistor of the branch and a voltage across the respective pre-charge resistor of the branch upon a first period of a pre-charge operation elapsing; calculating a sum of the respective branch currents of the plurality of branches; comparing the calculated sum with a battery current flowing through at least one battery pack of the plurality of battery packs; and determining, by a main control circuit that a pre-charge resistor of at least one of the branches is operating abnormally in response to the calculated sum and the battery current are different.

The method of determining the abnormality of the pre-charge resistor of the battery system may further include: for each branch: calculating a branch charging slope based on a difference between a capacitor voltage of the respective capacitor of the branch upon a second period of the pre-charge operation elapsing and the voltage of the respective capacitor of the branch upon a third period of the pre-charge operation elapsing; comparing the calculated branch charging slope with a predetermined reference slope; and determining, by the main control circuit, that the respective pre-charge resistor of the branch is operating abnormally based on the calculated branch charging slope being greater than the reference slope.

The method may further include: for each branch: measuring a branch charging time at which the voltage charged to the respective capacitor of the branch reaches a voltage of at least one battery pack of the plurality of battery packs; comparing the measured branch charging time with a predetermined reference time; and determining, by the main control circuit, that the respective pre-charge resistor of the branch is operating abnormally based on the measured branch charging time being longer than the reference time.

In some examples, the reference time may be the branch charging time of a plurality of pre-charge resistors in a normal state.

### [Advantageous Effects]

A method of determining whether a pre-charge resistor is abnormal and a battery system to which the same is applied are provided.

### [Brief Description of the Drawings]

FIG. 1 is a view showing a configuration of a battery system according to an embodiment.
FIG. 2 is a view illustrating a method for detecting deterioration of a pre-charge resistor during a pre-charge operation according to an embodiment.
FIG. 3 is a view of a curve showing a voltage fluctuation of one of a plurality of capacitors during a pre-charge operation according to an embodiment.

### [Detailed Description]

Hereinafter, embodiments disclosed in the present specification will be described in detail with reference to the accompanying drawings. In the present specification, the same or similar components will be denoted by the same or similar reference numerals, and an overlapped description thereof will be omitted. The terms "module" and "unit" for components used in the following description are used only in order to easily make a specification. Therefore, these terms do not have meanings or roles that distinguish them from each other in themselves. Further, in describing embodiments of the present specification, when it is determined that a detailed description of the well-known art associated with the present invention may obscure the gist of the present invention, it will be omitted. In addition, the accompanying drawings are provided only in order to allow embodiments disclosed in the present specification to be easily understood and are not to be interpreted as limiting the spirit disclosed in the present specification, and it is to be understood that the present invention includes all modifications, equivalents, and substitutions without departing from the scope and spirit of the present invention.

Terms including ordinal numbers such as first, second, and the like will be used only to describe various components, and are not interpreted as limiting these components. The terms are only used to differentiate one component from other components.

It is to be understood that when one component is referred to as being "connected" or "coupled" to another component, it may be connected or coupled directly to another component or be connected or coupled to another component with the other component intervening therebetween. On the other hand, it is to be understood that when one component is referred to as being "connected or coupled directly" to another component, it may be connected to or coupled to another component without another component intervening therebetween.

It will be further understood that terms "comprise" or "have" used in the present specification specify the presence of stated features, numerals, steps, operations, components, parts, or a combination thereof, but do not preclude the presence or addition of one or more other features, numerals, steps, operations, components, parts, or a combination thereof.

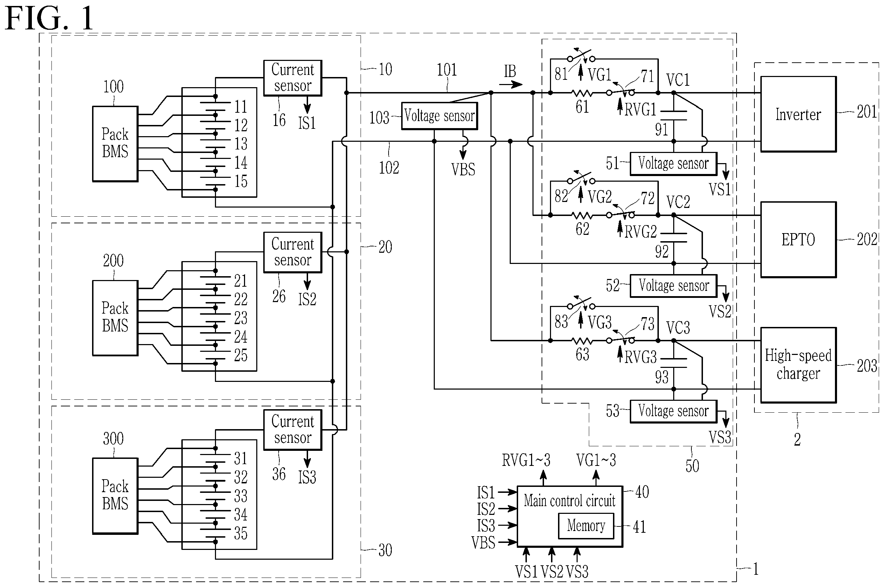

FIG. 1 is a view showing a configuration of a battery system according to an embodiment.

The battery system 1 includes a plurality of battery packs 10-30, a main control unit (MCU) such as a main control circuit 40, and a relay device 50.

FIG. 1 shows that the number of a plurality of battery packs is three, but the invention is not limited thereto, and the battery system 1 may include four or more battery packs. Also, in FIG. 1, a plurality of battery packs 10-30 are illustrated as being connected in parallel, but two or more battery packs may be connected in series and a plurality of battery packs that are connected in series may be connected in parallel.

A vehicle 2 includes an inverter 201, an Electric Power Take Off (EPTO) 202, and a high-speed charger 203. The EPTO 202 may include a battery, an electric motor, a hydraulic pump, a smart electronic control system, and the like. FIG. 1 shows an example of the configurations connected to the battery system 1 among the configurations of the vehicle 2, and other configurations such as a DC-DC converter for 12 V, a DC-DC converter for 24 V, and an On Board Charger (OBC) may be further connected.

A plurality of battery packs 10-30 are connected in parallel to each other, and both terminals of a plurality of battery packs 10-30 are connected to the relay device 50 through lines 101 and 102, respectively.

Each of a plurality of battery packs 10-30 includes a plurality of battery cells 11-15, 21-25, and 31-35, a plurality of pack battery management systems 100 to 300, and current sensors 16, 26, and 36. Hereinafter, the pack battery management system is referred to as a pack Battery Management System (BMS). FIG. 1 shows that each of a plurality of battery packs 10-30 include five battery cells 11-15, 21-25, and 31-35, which is an example, but the invention is not limited thereto. Also, although not shown in FIG. 1, a relay may be connected between at least one of both ends of each of a plurality of battery packs 10-30 and at least corresponding to one of two lines 101 and 102.

Each of a plurality of pack BMSs 100 to 300 is connected to a plurality of battery cells 11-15, 21-25, and 31-35, and measures a cell voltage of a plurality of battery cells 11-15, 21-25, and 31-35. Each of a plurality of pack BMS 100 to 300 may acquire voltage of the battery packs 10, 20, and 30, a battery pack current, and a temperature of the battery pack. Each of a plurality of pack BMSs 100 to 300 may control a charging and discharging current of the battery pack 10-30 based on the cell voltage and the battery pack current of a plurality of battery cells 11-15, 21-25, and 31-35, and may control a cell balancing operation for a plurality of battery cells 11-15, 21-25, and 31-35.

Each of a plurality of current sensors 16, 26, and 36 may measure the battery pack current flowing through the corresponding battery packs 10, 20, and 30, respectively, and may transmit current detection signals IS1, IS2, and IS3 indicating the measured battery pack current to the main control circuit 40. In this case, a plurality of current sensors 16, 26, and 36 may also transmit the current detection signals IS1, IS2, and IS3 to a plurality of pack BMSs 100 to 300.

The main control circuit 40 may receive information such as the cell voltage of a plurality of battery cells 11-15, 21-25, and 31-35 from a plurality of pack BMSs 100 to 300, and the voltage, the current, and the temperature of a plurality of battery packs 10, 20, and 30. The main control circuit 40 may supply a power control signal to a plurality of battery packs 10, 20, and 30 in order to supply electric power required for a vehicle operation, and may supply a charging control signal to charge a plurality of battery packs 10, 20, and 30. In addition, the main control circuit 40 may perform control necessary for the operation of the battery system 1, and when an abnormal state of the battery system 1 is detected, a protection operation may be started and controlled. The main control circuit 40 may include a memory 41, and information necessary for the operation of the battery system 1 may be stored in the memory 41. For example, information necessary for determining whether the pre-charge resistor is abnormal during the pre-charge operation may be stored in the memory 41.

The relay device 50 may include a plurality of pre-charge resistors 61 to 63, a plurality of pre-charge switches 71 to 73, a plurality of main switches 81 to 83, and a plurality of capacitors 91 to 93. The relay device 50 controls the switching operation of a plurality of pre-charge switches 71 to 73 according to a plurality of pre-charge gate voltages RVG1 to RVG3 received from the main control circuit 40, and controls the switching operation of a plurality of main switches 81 to 83 according to a plurality of gate voltages VG1 to VG3.

In the relay device 50, one of terminals of a plurality of pre-charge resistors 61 to 63 and a plurality of main switches 81 to 83 are connected to the line 101, and the other terminals of a plurality of main switches 81 to 83 are connected to the corresponding configurations in the vehicle 2. The other terminal of each of a plurality of pre-charge resistors 61 to 63 is connected to one terminal of a corresponding one of a plurality of pre-charge switches 71 to 73, and the other terminal of a plurality of pre-charge switches 71 to 73 is connected to the corresponding configuration in the vehicle 2. The other terminals of the pre-charge switch 71 and the main switch 81 are connected to one of two input terminals of the inverter 201, and the other terminals of the pre-charge switch 72 and the main switch 82 are connected to one of two input terminals of the EPTO 202, and the other terminals of the pre-charge switch 73 and the main switch 83 are connected to one of two input terminals of the high-speed charger 23. Each of a plurality of capacitors 91 to 93 is connected between the other terminal of a corresponding one of a plurality of pre-charge switches 71 to 73 and the line 102. Each of a plurality of voltage sensors 51-53 is connected to both ends of a corresponding one of a plurality of capacitors 91 to 93, to measure the voltages VC1, VC2, and VC3 charged in a plurality of capacitors 91 to 93, and may transmit a plurality of voltage detection signals VS1, VS2, and VS3 to the main control circuit 40.

The voltage sensor 103 may be connected to between the line 101 and the line 102 to measure a battery voltage VB, which is a voltage across both terminals of the battery system 1, and may transmit a voltage detection signal VBS indicating the measured battery voltage VB to the main control circuit 40.

The pre-charge operation may be an operation to block a surge current from being generated by pre-connecting the battery system 1 and the vehicle 2 through the pre-charge resistor and the pre-charge switch before turning on the main switch. When the resistance is increased due to the deterioration of the pre-charge resistor, since the various problems mentioned above occur, the main control circuit 40 according to an embodiment detects the deterioration of a plurality of pre-charge resistors during the pre-charge operation. During the pre-charge operation, the main control circuit 40 may turn on a plurality of main switches 81 to 83 before a predetermined time before a plurality of main switches 81 to 83 are in the turn-off state and the pre-charge operation is completed during the pre-charge operation. Subsequently, the main control circuit 40 may turn on a plurality of main switches 81 to 83, and then turn off a plurality of pre-charge switches 71 to 73.

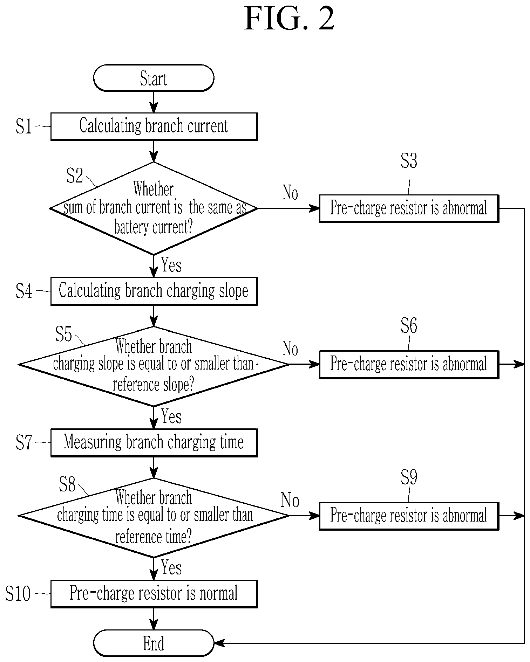

Hereinafter, a method for detecting the deterioration of the pre-charge resistor during the pre-charge operation according to an embodiment is described with reference to FIG. 2.

FIG. 2 is a view illustrating a method for detecting a deterioration of a pre-charge resistor during a pre-charge operation according to an embodiment.

In FIG. 1, during the pre-charge operation, the electric path configured of the pre-charge resistors 61, 62, and 63, the on-state pre-charge switches 71, 72, and 73, and the capacitors 91, 92, and 93, which are respectively connected between battery system 1 and the inverter 21, the EPTO 22, and the high-speed charger 23, is defined as a branch.

After the pre-charge operation is started, each of a plurality of capacitors 91 to 93 may be charged by the battery voltage VB so that the voltage of each of the plurality of capacitors 91 to 93 may rise for a predetermined delay period to be converged to the battery voltage VB. At this time, the delay period is determined according to a product (RC) of the resistance value R of the pre-charge resistor of each branch and the capacitance C of the capacitor, which is called a time constant (T). In an embodiment, the lapse of the time during the pre-charge operation is divided into a unit of the time constant, and the determination of whether the pre-charge resistor is abnormal in step 3 is performed. However, dividing the time lapse by a unit of the time constant is only one of various embodiments in which the invention is implemented, and the invention is but is not limited thereto. That is, it is possible to detect the abnormalities in the pre-charge resistor at an appropriate time according to the design. The abnormality of the pre-charge resistor means that the resistance value is increased due to the deterioration of the pre-charge resistor.

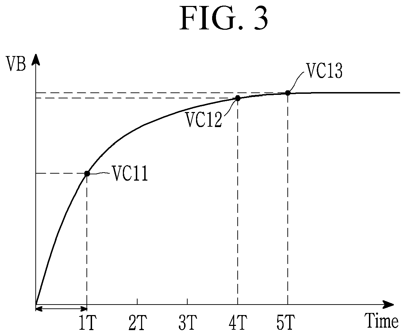

FIG. 3 is a view of a curve showing a voltage fluctuation of one of a plurality of capacitors during a pre-charge operation according to an embodiment.

As shown in FIG. 3, the voltage VC1, which is a voltage of two terminals of the capacitor 91, rises from the start time of the pre-charge, and when the period of 1T elapses, the voltage VC1 reaches the voltage level VC11, and when the period of 4T elapses, it reaches the voltage level VC12, and when the period of 5T elapses, it reaches substantially the same voltage level VC13 as the battery voltage VB. Other voltages VC2 and VC3 also have a waveform similar to the curve shown in FIG. 3. However, the time constant T may be different for each pre-charge resistor and capacitor.

First, the main control circuit 40 receives the voltage detection signals VBS and VS1 to VS3 indicating the battery voltage VB and a plurality of capacitor voltages VC1 to VC3 at the time of 1T, and calculates a branch current (S1). Based on the voltage value indicated by each of the voltage detection signals VBS and VS1 to VS3, the current I1 of the first branch connected to inverter 21, the current I2 of the second branch connected to the EPTO 22, and the current I3 of the third branch connected to the high-speed charger 23 are calculated. In this case, the main control circuit 40 may use the resistance value of each of a plurality of pre-charge resistors 61 to 63 stored in the memory 41. For example, the main control circuit 40 calculates the current I1 by dividing the voltage obtained by subtracting the voltage level VC11 of the voltage VC1 at the time 1T from the battery voltage VB by the resistance value of the pre-charge resistor 61 stored in the memory 41, calculates the current I2 by dividing the voltage obtained by subtracting the voltage level of voltage VC2 from the battery voltage VB at the time of 1T by the resistance value of the pre-charge resistor 62 stored in the memory 41, and calculates the current I3 by dividing the voltage obtained by subtracting the voltage level of the voltage VC3 from the battery voltage VB at the time of 1T by the resistance value of the pre-charge resistor 63 stored in the memory 41.

The main control circuit 40 determines whether the result of summing the currents I1 to I3 (the sum of the branch currents) is the same as the battery current (S2). The main control circuit 40 may receive the current detection signals IS1 to IS3 from the current sensors 16, 26, and 36 of a plurality of battery packs 10, 20, and 30, respectively, and add the current values indicated by the current detection signals IS1 to IS3 to calculate the battery current, which is the current of the battery system 1. However, the present invention is not limited thereto, and a current sensor may be positioned in any one of line 101 and line 102 to measure the battery current.

As the determining result of S2, if the sum of the branch currents is the same as the battery current, the pre-charge operation continues. As the determining result of S2, if the sum of the branch currents is different from the battery current, the main control circuit 40 may determine that at least one of a plurality of pre-charge resistors 61 to 63 is abnormal (S3). That is, when the resistance value is increased due to the deterioration of at least one of a plurality of pre-charge resistors 61 to 63, at least corresponding one of the currents 11-13 may be different from the actual branch current. The battery current IB is actually the sum of a plurality of branch currents, and the currents I1 to I3 calculated by the main control circuit 40 are the currents based on the resistance value stored in the memory 41, thereby a difference occurs between the stored resistance and the actual resistance due to the deterioration of the pre-charge resistor. Due to this difference, the battery current IB and the sum (I1+I2+I3) of the calculated branch currents are different. Accordingly, it may be confirmed that the main control circuit 40 has the pre-charge resistor of which the resistance value is increased due to the deterioration among a plurality of pre-charge resistors 61 to 63.

As the pre-charge operation continues, at the time 4T, the main control circuit 40 calculates a branch charge slope by using a plurality of capacitor voltages VC1 to VC3 (S4). For example, the main control circuit 40 may calculate the branch charging slope by dividing the value obtained by subtracting the voltage level VC11 of the voltage VC1 of the timing 1T from the voltage level VC12 of the voltage VC1 at the timing 4T by the time 3T. By the same manner, the main control circuit 40 may calculate each branch charging slope by dividing the value obtained by subtracting the voltage level at the time 1T from the voltage at the time 4T of the voltages VC2 and VC3 by the time 3T.

The main control circuit 40 compares each branch charging slope with a reference slope, and determines whether each branch charging slope is equal to or greater than the reference slope (S5). The reference slope may be set as the branch charging slope when the pre-charge resistor is in a normal state. The step S5 may be performed for each branch.

As the determining of S5, if the branch charging slope is smaller than the reference slope, the main control circuit 40 determines that the pre-charge resistor of the corresponding branch is abnormal (S6).

As the determining of S5, if all branch charging slopes are equal to or greater than the reference slope, the main control circuit 40 continues the pre-charge operation. As the resistance value increases as the pre-charge resistor deteriorates, the rising slopes of the voltages VC1, VC2, and VC3 decrease. Accordingly, the main control circuit 40 calculates the charging slope for each branch based on this and compares it with the reference slope, thereby determining that the pre-charge resistor of the branch below the reference slope has the abnormality due to the deterioration.

As the pre-charge operation continues, the main control circuit 40 measures the branch charging time at which the level of a plurality of voltages VC1 to VC3 reaches the battery voltage VB (S7). As shown in FIG. 3, if the time 5T has elapsed, the voltage VC1 reaches the battery voltage VB, where the time 5T is differentiated depending on the resistance value of the pre-charge resistor of each branch.

The main control circuit 40 compares a branch charging time of each of a plurality of branches with a reference time, and determines whether each of a plurality of branch charging times is equal to or less than the reference time (S8). If the resistance value increases due to the deterioration of the pre-charge resistor, the actually measured time 5T is longer than the time 5T based on the pre-charge resistor of the normal state. The reference time may be the time 5T determined by the steady state pre-charge resistor.

As the determining result of S8, the main control circuit 40 determines that the pre-charge resistor of the corresponding branch is abnormal when the time among a plurality of branch charging times is longer than the reference time (S9).

As the determining result of S8, if all of the plurality of branch charging times are less than or equal to the reference time, the main control circuit 40 determines that all of the pre-charge resistors are normal (S10).

As such, the embodiment may determine whether the pre-charge resistor is abnormal through three steps during the period in which the pre-charge operation is performed. If it is determined that the pre-charge resistor is abnormal, the pre-charge operation is stopped, and the main control circuit 40 may inform that the abnormality occurs in the pre-charge resistor through an interface (not shown) provided in at least one of the battery system 1 and the vehicle 2.

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. A battery system comprising:
a plurality of battery packs including a plurality of battery cells, each battery pack including a respective first terminal;
a plurality of branches, each branch comprising:
a respective pre-charge resistor including a first terminal that is connected to each of the first terminals of the plurality of battery packs and a second terminal;
a respective pre-charge switch, including a first terminal that is connected to a corresponding second terminal of the pre-charge resistor and a second terminal;
a capacitor including a first terminal that is connected to the second terminal of the pre-charge switch; and
a main control circuit configured to determine whether of the pre-charge resistors of the plurality of branches are operating abnormally based on a comparison of a sum of a plurality of branch currents with a battery current flowing through at least one battery pack, wherein, for each branch, the branch current is calculated using a pre-stored value of a resistance of the pre-charge resistor of the branch and a voltage across the pre-charge resistor of the branch, and wherein the comparison is upon a first period of a pre-charge operation elapsing.

2. The battery system of claim 1, wherein
the main control circuit is configured to:
calculate, for each branch, a branch charging slope; and
determine for a branch of the plurality of branches having a branch charging slope smaller than a predetermined reference slope, the pre-charge resistor of the branch is operating abnormally based on a difference between a capacitor voltage of the capacitor of the branch upon a second period of the pre-charge operation elapsing and the capacitor voltage upon a third period of the pre-charge operation elapsing.

3. The battery system of claim 2, wherein
the reference slope is a branch charging slope of a plurality of pre-charge resistors in a normal state.

4. The battery system of claim 2, wherein
the first period corresponds to a time constant defined by resistance values of of thehe pre-charge resistors of the plurality of branches and capacitance values of the capacitors of the plurality of branches, and
the second period corresponds to a predetermined integer multiple of the time constant.

5. The battery system of claim 2, wherein
the main control circuit is configured to:
for each branch of the plurality of branches, measure a branch charging time that a voltage charged to the capacitor of the branch reaches a voltage of at least one of the plurality of battery packs; and
determine, for a branch of the plurality of branches having a branch charging time that is longer than a predetermined reference time, that the pre-charge resistor of the branch is operating abnormally based on the branch charging time.

6. The battery system of claim 5, wherein
the reference time is a branch charging time of a plurality of pre-charge resistors in a normal state.

7. The battery system of claim 1, wherein
the first period corresponds to a time constant defined by resistance values of the pre-charge resistors of the plurality of branches and capacitance values of of thethe capacitors of the plurality of branches.

8. A method of determining an abnormality of a pre-charge resistor of a battery system including a plurality of battery packs including a plurality of battery cells, each battery pack including a respective first terminal, the battery system further including a plurality of branches, each branch including a respective pre-charge resistor, a respective pre-charge switch, and a respective capacitor, wherein a first terminal of of the respective pre-charge resistor is connected to each respective first terminal of the plurality of battery packs, wherein a first terminal of of thethe respective pre-charge switch is connected to a second terminal of of thethe respective pre-charge resistor, and a first terminal of the respective capacitor is connected to a second terminal ofof thethe respective pre-charge switch, the method comprising:
for each branch, calculating a branch current of the branch using a pre-stored resistance of thevalue of the respective pre-charge resistor of the branch and a voltage across the respective pre-charge resistor of the branch upon a first period of a pre-charge operation elapsing;
calculating a sum of the respective branch currents of the plurality of branches;
comparing the calculated sum with a battery current flowing through at least one battery pack of the plurality of battery packs; and
determining, by a main control circuit that a pre-charge resistor of at least one of the branches is operating abnormally in response to the calculated sum and the battery current are different.

9. The method of claim 8, further comprising:
for each branch:
calculating a branch charging slope based on a difference between a capacitor voltage of the respective capacitor of the branch upon a second period of the pre-charge operation elapsing and the voltage of the respective capacitor of the branch upon a third period of the pre-charge operation elapsing;
comparing the calculated branch charging slope with a predetermined reference slope; and
determining, by the main control circuit, that the respective pre-charge resistor of the branch is operating abnormally based on the calculated branch charging slope being greater than the reference slope.

10. The method of claim 9, wherein
the reference slope is the branch charging slope of a plurality of pre-charge resistors in a steady state.

11. The method of claim 9, further comprising:
for each branch:
measuring a branch charging time at which the voltage charged to the respective capacitor of the branch reaches a voltage of at least one battery pack of the plurality of battery packs;
comparing the measured branch charging time with a predetermined reference time; and
determining, by the main control circuit, that the respective pre-charge resistor of the branch is operating abnormally based on the measured branch charging time being longer than the reference time.

12. The method of claim 11, wherein
the reference time is the branch charging time of a plurality of pre-charge resistors in a normal state.
